(19) Europäisches Patentamt European Patent Office Office européen des brevets

(11) **EP 4 187 369 A1**

(12) **EUROPEAN PATENT APPLICATION**
published in accordance with Art. 153(4) EPC

(43) Date of publication:
**31.05.2023 Bulletin 2023/22**

(21) Application number: **21850613.7**

(22) Date of filing: **19.07.2021**

(51) International Patent Classification (IPC):
***G06F 7/58*** *(2006.01)*

(52) Cooperative Patent Classification (CPC):
**G06F 7/58**

(86) International application number:
**PCT/CN2021/107084**

(87) International publication number:
**WO 2022/022311 (03.02.2022 Gazette 2022/05)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.07.2020 CN 202010765593**

(71) Applicant: **Sanechips Technology Co., Ltd. Shenzhen, Guangdong 518055 (CN)**

(72) Inventor: **CAI, Wanjie Shenzhen, Guangdong 518057 (CN)**

(74) Representative: **Canzler & Bergmeier Patentanwälte Partnerschaft mbB Despag-Straße 6 85055 Ingolstadt (DE)**

(54) **METHOD AND APPARATUS FOR GENERATING PSEUDO-RANDOM SEQUENCE, ELECTRONIC DEVICE, AND STORAGE MEDIUM**

(57) A method and an apparatus for generating a pseudo-random sequence, an electronic device, and a computer-readable storage medium. The method for generating a pseudo-random sequence comprises: performing (100) an AND operation and an XOR operation on M bit values of a first sequence to obtain an $(A+m)^{th}$ bit value of the first sequence; where M is an integer greater than or equal to 1, and A is an integer greater than or equal to 0 (100); and determining (101), according to the $(A+m)^{th}$ bit value of the first sequence, an $m^{th}$ bit value of the pseudo-random sequence (101).

100

Perform an AND operation and an XOR operation on M bit values of a first sequence to obtain an $(A+m)^{th}$ bit value of the first sequence, where M is an integer greater than or equal to 1, and A is an integer greater than or equal to 0

101

Determine, according to the $(A+m)^{th}$ bit value of the first sequence, an $m^{th}$ bit value of the pseudo-random sequence

FIG. 1

**Description**

The present application is based on and claims a priority from the Chinese patent application No. 202010765593.6 filed on July 31, 2020, the entire disclosure of which is incorporated herein by reference.

TECHNICAL FIELD

Embodiments of the present application relate to the field of communications, and in particular, to a method and an apparatus for generating a pseudo-random sequence, an electronic device, and a computer-readable storage medium.

BACKGROUND

The pseudo-random sequence, due to good randomness and related functions close to white noise and capabilities of being able to be pre-determined and repeated, is widely applied in the fields of channel estimation, signal scrambling, frequency hopping and the like in communication systems.

The 3rd Generation Partnership Project (3GPP) Long Term Evolution (LTE) or New Radio (NR) standard adopts a Gold sequence as a pseudo-random sequence, and currently, the occupied memory volume or execution time will increase with a length of the sequence during generation of the Gold sequence, thereby affecting the performance of the device.

SUMMARY

Embodiments of the present application provide a method and an apparatus for generating a pseudo-random sequence, an electronic device, and a computer-readable storage medium.

In a first aspect, an embodiment of the present application provides a method for generating a pseudo-random sequence, including: performing an AND operation and an XOR operation on M bit values of a first sequence to obtain an $(A+m)^{th}$ bit value of the first sequence; where M is an integer greater than or equal to 1, and A is an integer greater than or equal to 0; and determining, according to the $(A+m)^{th}$ bit value of the first sequence, an $m^{th}$ bit value of the pseudo-random sequence.

In a second aspect, an embodiment of the present application provides an electronic device, including: at least one processor; and a memory having at least one program stored thereon which, when executed by the at least one processor, causes the at least one processor to implement any method for generating a pseudo-random sequence as described above.

In a third aspect, an embodiment of the present application provides a computer-readable storage medium having a computer program stored thereon which, when executed by a processor, causes any method for generating a pseudo-random sequence as described above to be implemented.

In a fourth aspect, an embodiment of the present application provides an apparatus for generating a pseudo-random sequence, including: a calculation module configured to calculate, according to an initial value of a first sequence, M bit values of the first sequence; where M is an integer greater than or equal to 1; a logic operation module configured to perform an AND operation and an XOR operation on the M bit values to obtain an $(A+m)^{th}$ bit value of the first sequence; where A is an integer greater than or equal to 0; and a determination module configured to determine, according to the $(A+m)^{th}$ bit value of the first sequence, an $m^{th}$ bit value of the pseudo-random sequence.

In the method for generating a pseudo-random sequence provided in the embodiments of the present application, an AND operation and an XOR operation are simply performed on M bit values of a first sequence to obtain an $(A+m)^{th}$ bit value of the first sequence, and thus an $m^{th}$ bit value of the pseudo-random sequence. Since the AND operation and the XOR operation are both simple logic operations, the storage space and processor resources are saved, while the operation speed is increased, thereby improving performance of the device.

BRIEF DESCRIPTION OF DRAWINGS

FIG. 1 is a flowchart of a method for generating a pseudo-random sequence according to an embodiment of the present application;
FIG. 2 is a schematic diagram illustrating an AND operation and an XOR operation performed according to an embodiment of the present application; and
FIG. 3 is a block diagram of an apparatus for generating a pseudo-random sequence according to another embodiment of the present application.

DETAIL DESCRIPTION OF EMBODIMENTS

In order to make those skilled in the art better understand the technical solutions of the present application, the following describes the method and apparatus for generating a pseudo-random sequence, the electronic device, and the computer-readable storage medium of the present application in detail with reference to the accompanying drawings.

Example embodiments will be described more sufficiently below with reference to the accompanying drawings, but which may be embodied in different forms and should not be construed as limited to the embodiments set forth herein. Rather, these embodiments are provided so that the present application will be thorough and complete, and will fully convey the scope of the present application to those skilled in the art.

The embodiments of the present application and features thereof may be combined with each other as long as they are not contradictory.

As used herein, the term "and/or" includes any and all combinations of at least one associated listed item.

The terminology used herein is for the purpose of describing specific embodiments only and is not intended to limit the present application. As used herein, the singular forms "a", "an" and "the" are intended to include the plural forms as well, unless the context clearly indicates otherwise. It will be further understood that as used herein, the terms "comprise" and/or "consist of ..." specify the presence of the stated features, integers, steps, operations, elements, and/or components, but do not preclude the presence or addition of at least one other feature, integer, step, operation, element, component, and/or group thereof.

Unless otherwise defined, all terms (including technical and scientific terms) used herein have the same meaning as commonly understood by one of ordinary skill in the art. It will be further understood that terms, such as those defined in commonly used dictionaries, should be interpreted as having a meaning that is consistent with their meaning in the context of the existing art and the present application, and will not be interpreted in an idealized or overly formal sense unless expressly so defined herein.

The pseudo-random sequence adopted by 3GPP LTE or NR is a 31-bit Gold sequence, and is configured to produce polynomials of the 31-bit Gold sequence, such as formulas (1) to (3):

$$c(n) = \left[ x_1(n+N_C) + x_2(n+N_C) \right] \bmod 2 \qquad (1)$$

$$x_1(n+31) = \left[ x_1(n+3) + x_1(n) \right] \bmod 2 \qquad (2)$$

$$x_2(n+31) = \left[ x_2(n+3) + x_2(n+2) + x_2(n+1) + x_2(n) \right] \bmod 2 \qquad (3)$$

where Nc = 1600.

According to the polynomial iterative relations (1) to (3), the sequence c (n) is calculated from $x_1(n+N_C)$ and $x_2(n+N_C)$, and $x_1$ is initialized to: $x_1(0)=1$, $x_1(n)=0$; $n=1,2,3...30$ ; An initialization value of $x_2$ is calculated from $c_{init}$, i.e.,

$$c_{init} = \sum_{i=0}^{30} x_2(i) \cdot 2^i$$

; then a sequence $x_1(n_+N_C)$ and a sequence $x_2(n+N_C)$, and thus a final c(n) sequence, are obtained.

Currently, there are two methods for generating a pseudo-random sequence.

A first method includes: inputting initial values of $x_1$ and $x_2$, and calculating all sequences iteratively one by one according to the polynomial iterative relations (1) to (3), which may be implemented by software or hardware. This method occupies less device resources (including memory resources and processor resources), but has a lower calculation speed, and is not beneficial to real-time calculation.

A second method includes: obtaining an initial state sequence V0 from the initial values of $x_1$ and $x_2$, deriving a one-step state transition matrix M from a current state sequence to a next state sequence according to the iterative formulas, where the next state sequence may be obtained by multiplying the current state sequence by M, and generating all the sequences in a similar manner:

$$V1 = V_0 M \; ;$$

$$V_2 = V_1 M = V_0 M^2 \; ;$$

$$\dots$$

$$V_k = V_{k-1}M = V_0 \prod_1^k M = V_0 M^k \; .$$

An advantage of the second method is that a parallel processing computing power of the multi-operation unit is utilized, and 32-bits can be computed simultaneously; and a disadvantage of this method is that k power of M is desired to be calculated, which involves a large amount of accumulation and product calculation, wastes a large amount of storage space and processor resources, and thus influences performance of the device.

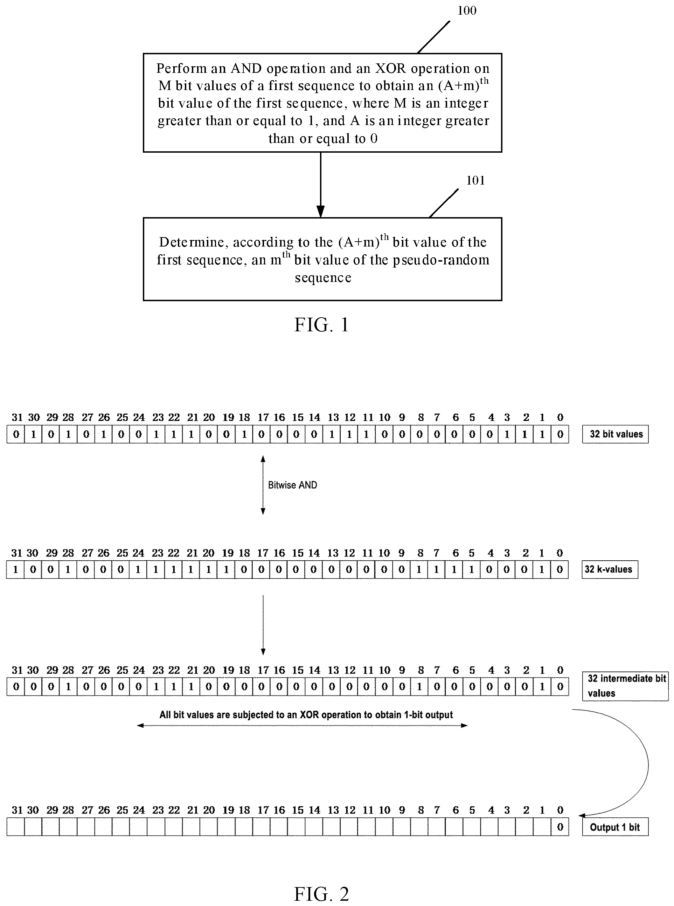

FIG. 1 is a flowchart of a method for generating a pseudo-random sequence according to an embodiment of the present application.

In a first aspect, referring to FIG. 1, an embodiment of the present application provides a method for generating a pseudo-random sequence, including the following operations 100 to 101.

At operation 100, performing an AND operation and an XOR operation on M bit values of a first sequence to obtain an $(A+m)^{th}$ bit value of the first sequence; where M is an integer greater than or equal to 1, and A is an integer greater than or equal to 0.

In some exemplary embodiments, M is less than or equal to a bit width of a processor. The optimal performance is achieved when the value of M is equal to the bit width of the processor. For example, when the bit width of the processor is 32, M may be any one of 4, 8, 16, and 32, but the optimal performance is achieved when M is 32. Other situations are similar.

In some exemplary embodiments, the M bit values include: a $j^{th}$ bit value to a $(j+M-1)^{th}$ bit value; where j is an integer greater than or equal to 0. For example, the M bit values include a $0^{th}$ bit value to an $(M-1)^{th}$ bit value, or a $1^{st}$ bit value to an $M^{th}$ bit value. The specific M bit values are not particularly limited in the embodiments of the present application.

In some exemplary embodiments, if the pseudo-random sequence to be generated is a Gold sequence, the first sequence may be an $x_2$ sequence. If the pseudo-random sequence to be generated is another sequence, the first sequence may also be another sequence. The specific form of the first sequence is not particularly limited in the embodiments of the present application.

In some exemplary embodiments, performing the AND operation and the XOR operation on M bit values of the first sequence to obtain the $(A+m)^{th}$ bit value of the first sequence includes:

performing an AND operation on an $i^{th}$ bit value in the M bit values and $k_{(m.i)}$ to obtain a corresponding $i^{th}$ intermediate bit value; where i is an integer greater than or equal to 1 and less than or equal to M, and $k_{(m.i)}$ is a proportionality coefficient corresponding to the $i^{th}$ bit value and m; and m is an integer greater than or equal to 0; and performing an XOR operation on M intermediate bit values to obtain the $(A+m)^{th}$ bit value of the first sequence.

In some exemplary embodiments, a value of $k_{(m.i)}$ is determined from an original proportionality coefficient of $x_2(i)$ split from $x_2(A+m)$, and when the original proportionality coefficient of $x_2(i)$ split from $x_2(A+m)$ is an even number, the value of $k_{(m.i)}$ is 0; when the original proportionality coefficient of $x_2(i)$ split from $x_2(A+m)$ is an odd number, the value of $k_{(m.i)}$ is 1.

FIG. 2 is a schematic diagram of an AND operation and an XOR operation taking M being 32 as an example. As shown in FIG. 2, 32 bit values are input and subjected to an AND operation with 32 k values in a bitwise manner to obtain 32 intermediate bit values, and the 32 intermediate bit values are subjected to an XOR operation obtain the $(A+m)^{th}$ bit value.

In some exemplary embodiments, if the pseudo-random sequence is a Gold sequence, A may take a value Nc, i.e., 1600. If the pseudo-random sequence is another sequence, A may also take another value. The specific value may be determined according to the actual situation, as long as the value of A can satisfy calculation of the $1^{st}$ bit value of the pseudo-random sequence. For the Gold sequence, since the $1^{st}$ bit value of the Gold sequence is calculated from $x_2(Nc)$, A taking the value of Nc is most efficient for calculation. Apparently, A may also take a value other than Nc, but further iterative calculation is required to obtain the $1^{st}$ bit value of the Gold sequence.

In some exemplary embodiments, before performing the AND operation on the $i^{th}$ bit value in the M bit values and $k_{(m.i)}$ to obtain the corresponding $i^{th}$ intermediate bit value, the method further includes: determining $k_{(m.i)}$ according to a first correspondence relationship among i, m and $k_{(m.i)}$.

In some exemplary embodiments, the first correspondence relationship may be implemented in various expressions, for example, in the form of a two-dimensional table, or in the form of a two-dimensional array, or in the form of a two-dimensional matrix. If a two-dimensional table is used, rows of the table may be i and columns may be m; alternatively, rows of the table may be m and columns may be i; and each cell is a corresponding value of $k_{(m,i)}$. Other situations are similar and are not repeated here.

In some exemplary embodiments, the AND operation and the XOR operation may be performed in a serial manner or in a parallel manner. In the parallel manner, an operation unit of the processor is sufficiently utilized, so that the pseudo-random sequence can be rapidly generated in real time, thereby saving the storage space, and improving the generation efficiency of the pseudo-random sequence. For example, in the case of 4 operation units, through timing analysis and according to the optimal 4 segments, the result of 4 bits can be calculated within 1 clock cycle. In other words, for the first sequence, the AND operations of 4 M-bit values can be performed simultaneously, thereby increasing the operation speed.

In some exemplary embodiments, performing the AND operation and the XOR operation in a parallel manner may specifically include: performing the AND operation and the XOR operation corresponding to m corresponding to a same segment in parallel. Each segment includes N bit values, and N is an integer greater than or equal to 2; and the segment is obtained by dividing the pseudo-random sequence.

In other words, the pseudo-random sequence is divided into at least one segment, each segment includes N bit values of the pseudo-random sequence. The calculation processes of the N bit values belonging to a same segment are performed in parallel, and the calculation process of each bit value includes an AND operation, an XOR operation, and operation 102.

In some exemplary embodiments, N is less than or equal to a maximum parallel number supported by a processor.

The Gold sequence is taken as an example to explain why the $(A+m)^{th}$ bit value of the first sequence can be obtained by performing an AND operation and an XOR operation on M features. Although the Gold sequence is taken as an example for description here, the method provided in the embodiments of the present application may also be used in generation of other pseudo-random sequences.

From the recursion formula $x_2(n+31)=[x_2(n+3)+x_2(n+2)+x_2(n+1)+x_2(n)]\mod 2$ for the $x_2$ sequence, $x_2(1570 + 31)$ can be calculated, i.e.,:

$$x_2(1601) = \left[x_2(1573) + x_2(1572) + x_2(1571) + x_2(1570)\right] \mod 2$$

$$= \left\{\begin{array}{l} \left[x_2(1545) + x_2(1544) + x_2(1543) + x_2(1542)\right]\mod 2+ \\ \left[x_2(1544) + x_2(1543) + x_2(1542) + x_2(1541)\right]\mod 2+ \\ \left[x_2(1543) + x_2(1542) + x_2(1541) + x_2(1540)\right]\mod 2+ \\ \left[x_2(1542) + x_2(1541) + x_2(1540) + x_2(1539)\right]\mod 2 \end{array}\right\} \mod 2$$

Since the mod2 operation reflects a parity of the result, the mod2 operation can be performed again by adding all bits together, so

$$x_2(1601) = \left[\begin{array}{l} x_2(1545) + 2\times x_2(1544) + 3\times x_2(1543) + 4\times x_2(1542)+ \\ 3\times x_2(1541) + 2\times x_2(1540) + x_2(1539) \end{array}\right]\mod 2$$

The above formula may be equivalent to firstly performing mod2 operation on $k_i \times x_2(i)$ before adding, and finally performing the mod2 operation for a further time. Therefore, the above formula may be rewritten as:

$$x_2(1601) = \left\{\begin{array}{l} \left[x_2(1545)\right]\mod 2+\left[2\times x_2(1544)\right]\mod 2 +\left[3\times x_2(1543)\right]\mod 2 + \\ \left[4\times x_2(1542)\right]\mod 2+\left[3\times x_2(1541)\right]\mod 2 + \\ \left[2\times x_2(1540)\right]\mod 2+\left[x_2(1539)\right]\mod 2 \end{array}\right\} \mod 2$$

For $[k_i \times x_2(n)]\mod 2$ , since $[k_i \times x_2(n)]\mod 2= (k_i \mod 2) \times [x_2(n)\mod 2]$, if $k_i$ (i.e., the original proportionality coefficient) is even, then $[k_i \times x_2(n)]\mod 2=0$; and if ki is odd, then $[k_i \times x_2(n)]\mod 2=x_2(n)\mod 2$. Therefore, the above formula may be simplified to:

$$x_2(1601) = \left\{ \left[ x_2(1545) \right] \bmod 2 + \left[ x_2(1543) \right] \bmod 2 + \left[ x_2(1541) \right] \bmod 2 + \left[ x_2(1539) \right] \bmod 2 \right\} \bmod 2$$

Then, $x_2(1545)$, $x_2(1543)$, $x_2(1541)$ and $x_2(1539)$ may be further split, and finally $x_2(1601)$ is split into a combination of $x_2(n)$, $n \in [0, M-1]$, so:

$$x_2(N_C + m) = \left[ \sum_{i=0}^{M-1} k_{(m,\ i)} * x_2(i) \right] \bmod 2 \quad ;$$

where $N_C = 1600$, $k_{(m,i)} \in [0,1]$, and $x2(i) \in [0,1]$, and
$y_{(m,\ i)} = k_{(m,\ i)} * x_2(i)$ may be implemented through an AND operation of (M-1) bits in a bitwise manner. That is, $y_{(m,\ i)} = k_{(m,\ i)} * x_2(i)$ is equivalent to $y_{(m,\ i)} = k_{(m,\ i)} \& x_2(i)$, and denoted by $y_{(m,i)}$, and since $[x_2(i) + x_2(i+1)] \bmod 2$ is equivalent to $x_2(i)^\wedge x_2(i+1)$, $x_2(N_C + m)$ may be implemented by an XOR operation, so:

$$x_2(N_C + m) = \left[ \sum_{i=0}^{M-1} y_{(m,i)} \right] \bmod 2 = y_{(m,0)} {}^\wedge y_{(m,1)} {}^\wedge y_{(m,2)\ldots} {}^\wedge y_{(m,\ M-1)} \quad ;$$

where $^\wedge$ represents the XOR operation. That is, obtaining the $(A+M)^{th}$ bit value of the first sequence involves firstly performing an AND operation on bit values of the M bits in a bitwise manner, and then performing an XOR operation on results of the AND operation of the M bits, to obtain the $(A+m)^{th}$ bit value of the first sequence, and thus an output of 1 bit value of the pseudo-random sequence.

At operation 101, determining, according to the $(A+m)^{th}$ bit value of the first sequence, an $m^{th}$ bit value of the pseudo-random sequence.

In some exemplary embodiments, determination of N bit values belonging to a same segment in the pseudo-random sequence is performed in parallel.

In some exemplary embodiments, before performing the AND operation and the XOR operation on M bit values of the first sequence to obtain the $(A+m)^{th}$ bit value of the first sequence, the method further includes:
calculating, according to an initial value of the first sequence, M bit values of the first sequence.

The following describes the calculation process of M bit values by taking a pseudo-random sequence being a Gold sequence as an example.

First, the $0^{th}$ bit value to the $30^{th}$ bit value, that is, an initial value of the first sequence, is calculated from tan initial value $c_{init}$. Specifically, the calculation is performed according to formula $c_{init} = \sum_{i=0}^{30} x_2(i) \cdot 2^i$.

Second, if there is a bit value having a position in the first sequence greater than 30 among the M bit values, the bit value having a position in the first sequence greater than 30 is calculated according to recursion formula

$$x_2(n+31) = \left[ x_2(n+3) + x_2(n+2) + x_2(n+1) + x_2(n) \right] \bmod 2 \quad .$$

In some exemplary embodiments, before determining, according to the $(A+m)^{th}$ bit value of the first sequence, the $m^{th}$ bit value of the pseudo-random sequence, the method further includes: acquiring, according to a preset second correspondence relationship between i and an $i^{th}$ bit value of a second sequence, an $(A+m)^{th}$ bit value of the second sequence; where i is an integer greater than or equal to 1 and less than or equal to M.

Accordingly, determining, according to the $(A+m)^{th}$ bit value of the first sequence, the $m^{th}$ bit value of the pseudo-random sequence includes: determining, according to the $(A+m)^{th}$ bit value of the first sequence and the $(A+m)^{th}$ bit value of the second sequence, the $m^{th}$ bit value of the pseudo-random sequence.

In some exemplary embodiments, if the pseudo-random sequence is a Gold sequence, the second sequence may be an $x_1$ sequence. Each bit value in the $x_1$ sequence may be calculated from the recursion formula $x_1(n+31) = [x_1(n+3) + x_1(n)] \bmod 2$, and stored, and directly called when a certain bit value of the second sequence is desired to be obtained.

In some exemplary embodiments, the second correspondence relationship may be implemented in various expressions, for example, in the form of a one-dimensional table, or in the form of a one-dimensional array, or in the form of a one-dimensional matrix. If a one-dimensional table is used, rows or columns of the table may be i; and a unit cell corresponding to each row or column is the $i^{th}$ bit value of the second sequence. Other situations are similar and are not repeated here.

In some exemplary embodiments, if the pseudo-random sequence is a Gold sequence, the $m^{th}$ bit value of the pseudo-random sequence is calculated from recursion formula $c(n)=[x_1(n+N_c)+x_2(n+N_C)]mod2$.

In the method for generating a pseudo-random sequence provided in the embodiments of the present application, M bit values of the first sequence are firstly calculated, and then subjected to an AND operation and an XOR operation to obtain an $(A+m)^{th}$ bit value of the first sequence, and thus an $m^{th}$ bit value of the pseudo-random sequence. Since the AND operation and the XOR operation are both simple logic operations, the storage space and processor resources are saved, while the operation speed is increased, thereby improving performance of the device.

It should be noted that the method for generating a pseudo-random sequence provided in the embodiments of the present application may be implemented by software or hardware, for example, by an AND gate and an XOR gate.

In a second aspect, an embodiment of the present application provides an electronic device, including:

> at least one processor; and
> a memory having at least one program stored thereon which, when executed by the at least one processor, causes the at least one processor to implement any method for generating a pseudo-random sequence as described above.

The processor is a device having a data processing capability, including but not limited to a central processing unit (CPU), or the like. The memory is a device with a data storage capability including but not limited to, a random access memory (RAM, more specifically SDRAM, DDR, etc.), a read-only memory (ROM), an electrically erasable programmable read-only memory (EEPROM) or a flash.

In some embodiments, the processor and the memory are connected to each other via a bus, and further connected to other components of a computing device.

In a third aspect, an embodiment of the present application provides a computer-readable storage medium having a computer program stored thereon which, when executed by a processor, causes any method for generating a pseudo-random sequence as described above to be implemented.

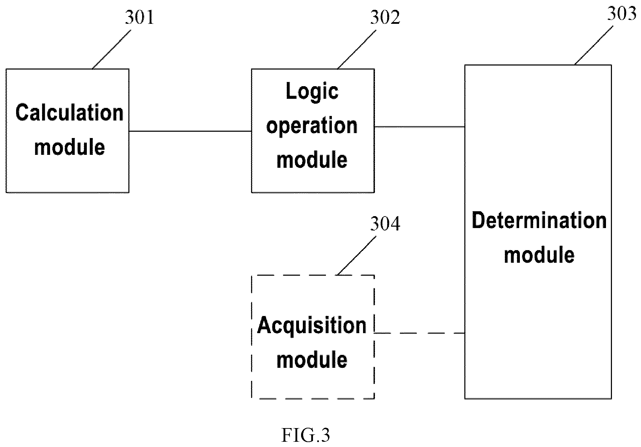

FIG. 3 is a block diagram of an apparatus for generating a pseudo-random sequence according to another embodiment of the present application.

In a fourth aspect, referring to FIG. 3, another embodiment of the present application provides an apparatus for generating a pseudo-random sequence, including:

> a calculation module 301 configured to calculate, according to an initial value of a first sequence, M bit values of the first sequence, where M is an integer greater than or equal to 1;
> a logic operation module 302 configured to perform an AND operation and an XOR operation on the M bit values to obtain an $(A+m)^{th}$ bit value of the first sequence, where A is an integer greater than or equal to 0; and
> a determination module 303 configured to determine, according to the $(A+m)^{th}$ bit value of the first sequence, an $m^{th}$ bit value of the pseudo-random sequence.

In some exemplary embodiments, the logic operation module 302 is specifically configured to:
perform an AND operation on an $i^{th}$ bit value in the M bit values and $k_{(m.i)}$ to obtain a corresponding $i^{th}$ intermediate bit value; where i is an integer greater than or equal to 1 and less than or equal to M, and $k_{(m.i)}$ is a proportionality coefficient corresponding to the $i^{th}$ bit value and m; and m is an integer greater than or equal to 0; and perform an XOR operation on M intermediate bit values to obtain the $(A+m)^{th}$ bit value of the first sequence.

In some exemplary embodiments, the logic operation module 302 is further configured to:
determine $k_{(m.i)}$ according to a first correspondence relationship among i, m and $k_{(m.i)}$.

In some exemplary embodiments, the AND operation and the XOR operation corresponding to m of a same segment are performed in parallel, and determination of bit values belonging to a same segment in the pseudo-random sequence is performed in parallel. Each segment includes N bit values, and N is an integer greater than or equal to 2; and the segment is obtained by dividing the pseudo-random sequence.

In some exemplary embodiments, N is less than or equal to a maximum parallel number supported by a processor.

In some exemplary embodiments, M is less than or equal to a bit width of a processor.

In some exemplary embodiments, the M bit values include: a $j^{th}$ bit value to a $(j+M-1)^{th}$ bit value; where j is an integer greater than or equal to 0.

In some exemplary embodiments, the apparatus further includes: an acquisition module 304 configured to acquire, according to a preset second correspondence relationship between i and an $i^{th}$ bit value of a second sequence, an $(A+m)^{th}$ bit value of the second sequence; where i is an integer greater than or equal to 1 and less than or equal to M.

Accordingly, the determination module 303 is specifically configured to: determine, according to the $(A+m)^{th}$ bit value of the first sequence and the $(A+m)^{th}$ bit value of the second sequence, an $m^{th}$ bit value of the pseudo-random sequence.

The specific implementation process of the apparatus for generating a pseudo-random sequence is the same as that of the method for generating a pseudo-random sequence in the foregoing embodiments, and thus is not repeated here.

Those of ordinary skill in the art will appreciate that all or some operations of the above described method, functional modules/units in the system and apparatus may be implemented as software, firmware, hardware, and suitable combinations thereof. In a hardware implementation, the division between the functional modules/units mentioned in the above description does not necessarily correspond to the division of physical components; for example, one physical component may have multiple functions, or one function or operation may be performed cooperatively by several physical components. Some or all physical components may be implemented as software executed by a processor, such as a CPU, a digital signal processor or microprocessor, or implemented as hardware, or implemented as an integrated circuit, such as an application specific integrated circuit. Such software may be distributed on a computer-readable medium which may include a computer storage medium (or non-transitory medium) and communication medium (or transitory medium). As is well known to those of ordinary skill in the art, the term computer storage medium includes volatile and nonvolatile, removable and non-removable medium implemented in any method or technology for storing information, such as computer-readable instructions, data structures, program modules or other data. The computer storage medium includes, but is not limited to, an RAM, an ROM, an EEPROM, a flash or any other memory technology, a CD-ROM, a digital versatile disc (DVD) or any other optical disc storage, a magnetic cartridge, a magnetic tape, a magnetic disk storage or any other magnetic memories, or may be any other medium used for storing the desired information and accessible by a computer. Moreover, it is well known to those ordinary skilled in the art that a communication medium typically includes a computer-readable instruction, a data structure, a program module, or other data in a modulated data signal, such as a carrier wave or other transport mechanism, and may include any information delivery medium.

The present disclosure has disclosed exemplary embodiments, and although specific terms are employed, they are used and should be interpreted merely in a generic and descriptive sense, not for purposes of limitation. In some instances, as would be apparent to one skilled in the art, features, characteristics and/or elements described in connection with a particular embodiment may be used alone or in combination with features, characteristics and/or elements described in connection with another embodiment, unless expressly stated otherwise. It will, therefore, be understood by those skilled in the art that various changes in form and details may be made therein without departing from the scope of the present application as set forth in the appended claims.

## Claims

1. A method for generating a pseudo-random sequence, comprising:

   performing an AND operation and an XOR operation on M bit values of a first sequence to obtain an $(A+m)^{th}$ bit value of the first sequence, where M is an integer greater than or equal to 1, and A is an integer greater than or equal to 0; and
   determining, according to the $(A+m)^{th}$ bit value of the first sequence, an $m^{th}$ bit value of the pseudo-random sequence.

2. The method according to claim 1, wherein performing the AND operation and the XOR operation on M bit values of the first sequence to obtain the $(A+m)^{th}$ bit value of the first sequence comprises:

   performing an AND operation on an $i^{th}$ bit value in the M bit values and $k_{(m.i)}$ to obtain a corresponding $i^{th}$ intermediate bit value, where i is an integer greater than or equal to 1 and less than or equal to M, and $k_{(m.i)}$ is a proportionality coefficient corresponding to the $i^{th}$ bit value and m; where m is an integer greater than or equal to 0; and
   performing an XOR operation on M intermediate bit values to obtain the $(A+m)^{th}$ bit value of the first sequence.

3. The method according to claim 2, wherein before performing the AND operation on the $i^{th}$ bit value in the M bit values and $k_{(m.i)}$ to obtain the corresponding $i^{th}$ intermediate bit value, the method further comprises:
   determining $k_{(m.i)}$ according to a first correspondence relationship among i, m and $k_{(m.i)}$.

4. The method according to any one of claims 1 to 3, wherein the AND operation and the XOR operation corresponding to m of a same segment are performed in parallel, and determination of bit values belonging to a same segment in the pseudo-random sequence is performed in parallel, wherein each segment comprises N bit values of the pseudo-random sequence, where N is an integer greater than or equal to 2; and the segment is obtained by dividing the pseudo-random sequence.

5. The method according to claim 4, wherein N is less than or equal to a maximum parallel number supported by a processor.

6. The method according to any one of claims 1 to 5, wherein M is less than or equal to a bit width of a processor.

7. The method according to any one of claims 1 to 6, wherein the M bit values comprise: a $j^{th}$ bit value to a $(j+M-1)^{th}$ bit value, where j is an integer greater than or equal to 0.

8. The method according to any one of claims 1 to 7, wherein performing the AND operation and the XOR operation on M bit values of the first sequence to obtain the $(A+m)^{th}$ bit value of the first sequence, the method further comprises: calculating, according to an initial value of the first sequence, M bit values of the first sequence.

9. The method according to any one of claims 1 to 7, wherein before determining, according to the $(A+m)^{th}$ bit value of the first sequence, the $m^{th}$ bit value of the pseudo-random sequence, the method further comprises: acquiring, according to a preset second correspondence relationship between i and an $i^{th}$ bit value of a second sequence, an $(A+m)^{th}$ bit value of the second sequence, where i is an integer greater than or equal to 1 and less than or equal to M; accordingly, determining, according to the $(A+m)^{th}$ bit value of the first sequence, the $m^{th}$ bit value of the pseudo-random sequence comprises: determining, according to the $(A+m)^{th}$ bit value of the first sequence and the $(A+m)^{th}$ bit value of the second sequence, the $m^{th}$ bit value of the pseudo-random sequence.

10. An electronic device, comprising:

    at least one processor; and
    a memory having at least one program stored thereon which, when executed by the at least one processor, causes the at least one processor to implement the method for generating a pseudo-random sequence according to any one of claims 1 to 9.

11. A computer readable storage medium having a computer program stored thereon which, when executed by a processor, causes the method for generating a pseudo-random sequence according to any one of claims 1 to 9 to be implemented.

12. An apparatus for generating a pseudo-random sequence, comprising:

    a calculation module configured to calculate, according to an initial value of a first sequence, M bit values of the first sequence, where M is an integer greater than or equal to 1;
    a logic operation module configured to perform an AND operation and an XOR operation on the M bit values to obtain an $(A+m)^{th}$ bit value of the first sequence, where A is an integer greater than or equal to 0; and
    a determination module configured to determine, according to the $(A+m)^{th}$ bit value of the first sequence, an $m^{th}$ bit value of the pseudo-random sequence.

100

Perform an AND operation and an XOR operation on M bit values of a first sequence to obtain an $(A+m)^{th}$ bit value of the first sequence, where M is an integer greater than or equal to 1, and A is an integer greater than or equal to 0

101

Determine, according to the $(A+m)^{th}$ bit value of the first sequence, an $m^{th}$ bit value of the pseudo-random sequence

FIG. 1

| 31 | 30 | 29 | 28 | 27 | 26 | 25 | 24 | 23 | 22 | 21 | 20 | 19 | 18 | 17 | 16 | 15 | 14 | 13 | 12 | 11 | 10 | 9 | 8 | 7 | 6 | 5 | 4 | 3 | 2 | 1 | 0 |
|---|---|---|---|---|---|---|---|---|---|---|---|---|---|---|---|---|---|---|---|---|---|---|---|---|---|---|---|---|---|---|---|
| 0 | 1 | 0 | 1 | 0 | 1 | 0 | 0 | 1 | 1 | 1 | 0 | 0 | 1 | 0 | 0 | 0 | 0 | 1 | 1 | 1 | 0 | 0 | 0 | 0 | 0 | 0 | 0 | 1 | 1 | 1 | 0 |

**32 bit values**

Bitwise AND

| 31 | 30 | 29 | 28 | 27 | 26 | 25 | 24 | 23 | 22 | 21 | 20 | 19 | 18 | 17 | 16 | 15 | 14 | 13 | 12 | 11 | 10 | 9 | 8 | 7 | 6 | 5 | 4 | 3 | 2 | 1 | 0 |
|---|---|---|---|---|---|---|---|---|---|---|---|---|---|---|---|---|---|---|---|---|---|---|---|---|---|---|---|---|---|---|---|
| 1 | 0 | 0 | 1 | 0 | 0 | 0 | 1 | 1 | 1 | 1 | 1 | 1 | 1 | 0 | 0 | 0 | 0 | 0 | 0 | 0 | 0 | 0 | 0 | 1 | 1 | 1 | 1 | 0 | 0 | 1 | 0 |

**32 k-values**

| 31 | 30 | 29 | 28 | 27 | 26 | 25 | 24 | 23 | 22 | 21 | 20 | 19 | 18 | 17 | 16 | 15 | 14 | 13 | 12 | 11 | 10 | 9 | 8 | 7 | 6 | 5 | 4 | 3 | 2 | 1 | 0 |
|---|---|---|---|---|---|---|---|---|---|---|---|---|---|---|---|---|---|---|---|---|---|---|---|---|---|---|---|---|---|---|---|
| 0 | 0 | 0 | 1 | 0 | 0 | 0 | 0 | 1 | 1 | 1 | 0 | 0 | 0 | 0 | 0 | 0 | 0 | 0 | 0 | 0 | 0 | 0 | 0 | 1 | 0 | 0 | 0 | 0 | 0 | 1 | 0 |

**32 intermediate bit values**

All bit values are subjected to an XOR operation to obtain 1-bit output

| 31 | 30 | 29 | 28 | 27 | 26 | 25 | 24 | 23 | 22 | 21 | 20 | 19 | 18 | 17 | 16 | 15 | 14 | 13 | 12 | 11 | 10 | 9 | 8 | 7 | 6 | 5 | 4 | 3 | 2 | 1 | 0 |
|---|---|---|---|---|---|---|---|---|---|---|---|---|---|---|---|---|---|---|---|---|---|---|---|---|---|---|---|---|---|---|---|
| | | | | | | | | | | | | | | | | | | | | | | | | | | | | | | | 0 |

**Output 1 bit**

FIG. 2

301

Calculation
module

302

Logic
operation
module

303

Determination
module

304

Acquisition
module

FIG.3

## INTERNATIONAL SEARCH REPORT

| International application No. |
| --- |
| **PCT/CN2021/107084** |

| A. | CLASSIFICATION OF SUBJECT MATTER |
| --- | --- |

G06F 7/58(2006.01)i

According to International Patent Classification (IPC) or to both national classification and IPC

| B. | FIELDS SEARCHED |
| --- | --- |

Minimum documentation searched (classification system followed by classification symbols)

G06F H04J H04B

Documentation searched other than minimum documentation to the extent that such documents are included in the fields searched

Electronic data base consulted during the international search (name of data base and, where practicable, search terms used)

CNPAT, CNKI, WPI, EPODOC: 伪随机序列, 与运算, 异或, 并行, 抽头, pseudo random sequence, prs, gold, sequence, and, xor, exclusive, parallel, tap coefficient

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | CN 102025389 A (ZTE CORPORATION) 20 April 2011 (2011-04-20) description paragraphs 0009-0092 | 1-12 |
| Y | CN 108023661 A (SANECHIPS TECHNOLOGY CO., LTD.) 11 May 2018 (2018-05-11) description paragraphs 0070-0083 | 1-12 |
| A | CN 102405602 A (HUAWEI TECHNOLOGIES CO., LTD.) 04 April 2012 (2012-04-04) entire document | 1-12 |
| A | CN 103873181 A (INSTITUTE OF AUTOMATION, CHINESE ACADEMY OF SCIENCES) 18 June 2014 (2014-06-18) entire document | 1-12 |
| A | CN 102891726 A (HUAWEI TECHNOLOGIES CO., LTD.) 23 January 2013 (2013-01-23) entire document | 1-12 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **16 September 2021** | **15 October 2021** |

| Name and mailing address of the ISA/CN | Authorized officer |
| --- | --- |
| **China National Intellectual Property Administration (ISA/ CN)** **No. 6, Xitucheng Road, Jimenqiao, Haidian District, Beijing 100088** **China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2021/107084**

| Patent document cited in search report | | | Publication date (day/month/year) | Patent family member(s) | | | Publication date (day/month/year) |
|---|---|---|---|---|---|---|---|
| CN | 102025389 | A | 20 April 2011 | WO | 2011029302 | A1 | 17 March 2011 |
| | | | | CN | 102025389 | B | 11 June 2014 |
| CN | 108023661 | A | 11 May 2018 | WO | 2018076894 | A1 | 03 May 2018 |
| CN | 102405602 | A | 04 April 2012 | CN | 102405602 | B | 02 April 2014 |
| | | | | WO | 2012106895 | A1 | 16 August 2012 |
| CN | 103873181 | A | 18 June 2014 | CN | 103873181 | B | 18 January 2017 |
| CN | 102891726 | A | 23 January 2013 | CN | 102891726 | B | 08 April 2015 |
| | | | | WO | 2014036829 | A1 | 13 March 2014 |

Form PCT/ISA/210 (patent family annex) (January 2015)

**REFERENCES CITED IN THE DESCRIPTION**

**Patent documents cited in the description**

- CN 202010765593